# EUROPEAN PATENT SPECIFICATION

(11) **EP 0 428 792 B1**
(45) Date of publication and mention of the grant of the patent: **28.02.1996**
(21) Application number: 89203003.2
(22) Date of filing: 24.11.1989
(51) Int. Cl.: B29C 33/72, B29C 43/50, B29C 43/34, B29C 43/18, B29L 31/34

(54) **Single strip molding apparatus**
Einzelband-Formvorrichtung
Appareil de moulage pour bande unique

(43) Date of publication of application: 29.05.1991
(60) Divisional application: 94202389.6
(73) Proprietor: FICO B.V., NL-6914 AD Herwen (NL)
(72) Inventor: Venrooij, Johannes Lambertus Gerardus Maria, NL-6921 KG Duiven (NL); Verwoerd, Wouter Bastiaan, NL-6581 RK Malden (NL)
(74) Representative: Hoijtink, Reinoud

(56) References cited:
- WO-A-89/06597
- BE-A- 549 039
- BE-A- 551 646
- DE-A- 2 239 310
- DE-B- 1 080 506
- DE-B- 1 094 402
- DE-B- 1 290 706
- DE-C- 488 318
- DE-C- 518 347
- FR-A- 370 199
- FR-A- 1 446 147
- FR-A- 2 036 655
- FR-A- 2 099 596
- GB-A- 811 873
- GB-A- 1 292 593
- GB-A- 2 131 736
- GB-A- 2 171 051
- US-A- 2 054 476
- US-A- 2 347 972
- US-A- 3 059 305
- US-A- 4 079 617
- US-A- 4 360 335
- US-A- 4 723 899
- MODERN PLASTICS INTERNATIONAL, vol. 12, no. 7, July 1982, pages 32-35, Lausanne, CH; G.R. SMOLUK: "The rush to robotics could mean a major boon to productivity"
- MODERN PLASTICS INTERNATIONAL, vol. 13, no. 11, November 1983, pages 43-45, Lausanne, CH; A. STERNFIELD: "Insert molding goes automatic"
- PATENT ABSTRACTS OF JAPAN, vol. 4, no. 128 (M-31)[610], 9th September 1980; & JP-A-55 87 517 (HITACHI SEISAKUSHO K.K.) 02-07-1980

## Description

This invention relates to a single-strip moulding apparatus according to the precharacterising part of claim 1.

For the moulding of electronic components, e.g. chips, moulding apparatus are used wherein a so-called leadframe supporting an electronic component, such as a chip is placed into a mould wherein the mould displays recesses for receiving the parts for moulding, and in addition cavities are arranged in the mould wherein measured quantities of moulding material are placed and wherein by supplying heat and exerting pressure in these cavities the moulding material becomes liquid, moves via channels intended for that purpose to the parts for moulding and, curing there, encapsulates the leadframe. The leadframe is subsequently removed from the moulding apparatus and subjected to further processing. Before starting the next moulding cycle, the mould is mechanically cleaned by cleaners. An apparatus of this type is known for example from Patent Abstracts of Japan, vol. 4, No. 128 (M-31)(610), 9 September 1980, & JP,A, 5587517 of 2 July 1980. This publication also discloses a protective cover that is moved to cover a moulding body positioned in the opening between two moulding halfs. After the cover is moved to protect the moulded body the cleaners are moved to clean the inside surfaces of the mould halfs.

From US-A-3,059,305 a moulding apparatus is known in which a reciprocating hopper is provided that combines the function of supplying moulding material and cleaning of the mould cavity. After moulding the object the moulding pushes the product outwardly of the mould and cleans the mould cavity. The mould press consists of two plungers pressing the moulding material in the cavity. From FR-A-2,099,596 a moulding apparatus is known which comprises a device for removing remainder parts of moulding material sticking to the mould halfs with a rotating brush mounted on a horizontal and vertical moving means, which means move synchronic with the moulding apparatus.

From BE-A-551646 a device for cleaning the surfaces of the mould halfs from an automatic moulding machine is known. The device comprises a rotating brush which brush is controlled by two ridges.

From GB-A-811873 a diecasting machine is known which comprises brush means that brushes the two dies simultaneously after they have been moved apart.

The object of the invention is to provide a single-strip moulding apparatus which combines a simple construction with a relatively high production rate.

This is achieved according to the invention by providing a single-strip moulding apparatus comprising a mould formed by two mould halves vertically movable relative to one another and closable onto one another, means for carrying moulding material into cavities of the mould, means for exerting pressure and supplying heat to said cavities to liquify the moulding material and channels for supplying said moulding material to recesses, means for heating the mould halves, means for cleaning the mould halves and means for removing a moulded product from the mould, characterized in that the moulding apparatus comprises an input carriage for placing a leadframe supporting at least one electronic component into one of the mould halves and in that the means for cleaning and for removing the formed product are unified into a cleaning-discharge unit, said cleaning-discharge unit removing the product from the one side, said input carriage for placing the leadframe supplying said leadframe from the other side of the mould and said cleaning-discharge unit and said input carriage performing a reciprocating movement into the mould.

By combining different processes such as cleaning, which has to take place after each moulding cycle, with the removal of the moulded product an optimal production rate is achieved.

Further embodiments of the invention are disclosed in the dependent claims.

According to a preferred embodiment the cleaning-discharge unit to perform a reciprocating movement, cleans during the backward movement the one mould half, removes in the forward movement the moulded product and cleans the other mould half in one operating stroke.

An optimal production rate is achieved by setting into operation the means for placing a subsequent leadframe in the mould immediately following the inward movement of the cleaning-discharge unit.

The means for placing a leadframe are formed by a first carriage movable over guide rails while the cleaning-discharge unit is placed on a second carriage which is movable over the same guide rails.

The invention will be further elucidated with reference to the drawings.

In the drawings:
figures 1-3 show schematically one complete cycle of the moulding apparatus according to the invention;
figure 4 shows a perspective view of the moulding apparatus according to the invention;
figure 5 shows on a larger scale a detail of the lowermost part of the moulding apparatus according to figure 4;
figure 6 shows a sectional view of the mould of the moulding apparatus from figures 4 and 5;
figure 7 shows a first alternative embodiment of the closing mechanism of the mould of the moulding apparatus according to the invention; and
figure 8 shows a second alternative embodiment of the closing mechanism of the mould of the moulding apparatus according to the invention.

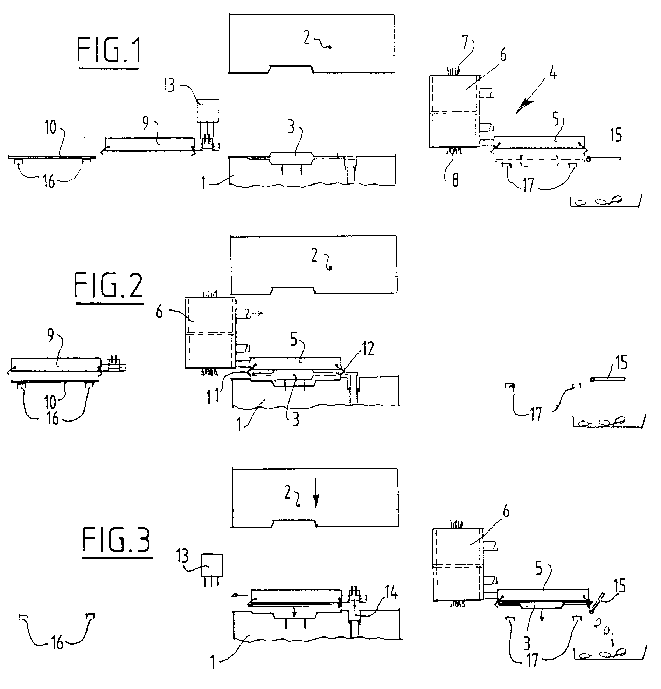

In figure 1 the mould, which consists of a fixedly positioned lower half and a vertically movable upper half, is open. It is assumed that the moulding has been completed during the previous cycle and that the moulded product 3 is still in the mould, that is, in the lower half 1. The cleaning-discharge unit 4 consists of a discharge carriage 5 and a brushing device 6 with brushes at the top 7 and brushes at the bottom 8. After opening of the mould (figure 1) the cleaning-discharge carriage 4 performs a movement to the left and thereby cleans the upper half of the mould (figure 2). The input carriage 9 likewise moves to the left to pick up a subsequent leadframe 10 from a store (not drawn) by means of a feed belt 16.

According to figure 2 the cleaning-discharge unit 4 then performs the return stroke wherein the discharge carriage 5 picks up the finished moulded frame 3 using schematically designated hook-shaped means 11, 12 and cleans the lower half of the mould.

Following on from the active stroke shown in figure 2 the input carriage 9 places the next leadframe into the mould. During the position in figure 1 the input carriage is thereby filled in cavities arranged for this purpose from a so-called pellet carriage 13 with pellet-shaped portions of moulding material which in the position as in figure 3 are placed into the cavities 14 intended for this purpose in the lower half 1 of the mould. The upper half 2 of the mould subsequently moves in the downward direction indicated with an arrow and closes (not drawn) onto the lower mould half, whereupon the moulding process begins. In the position drawn in figure 3 remnants of the moulding pellets are removed from the leadframe 3 with schematically designated means 15, after which the leadframe is discharged via a belt 17.

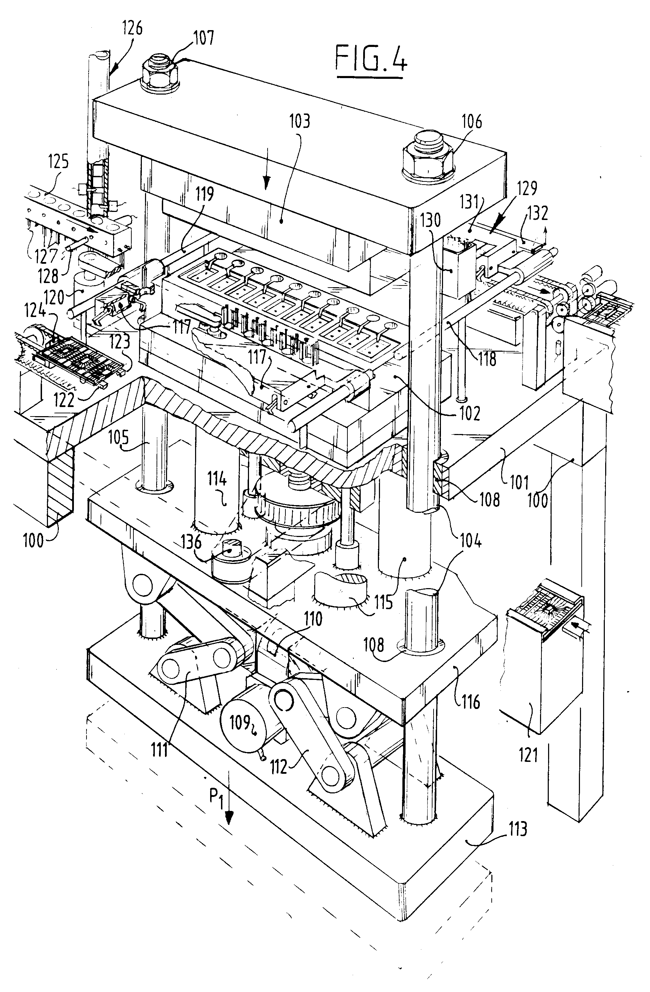

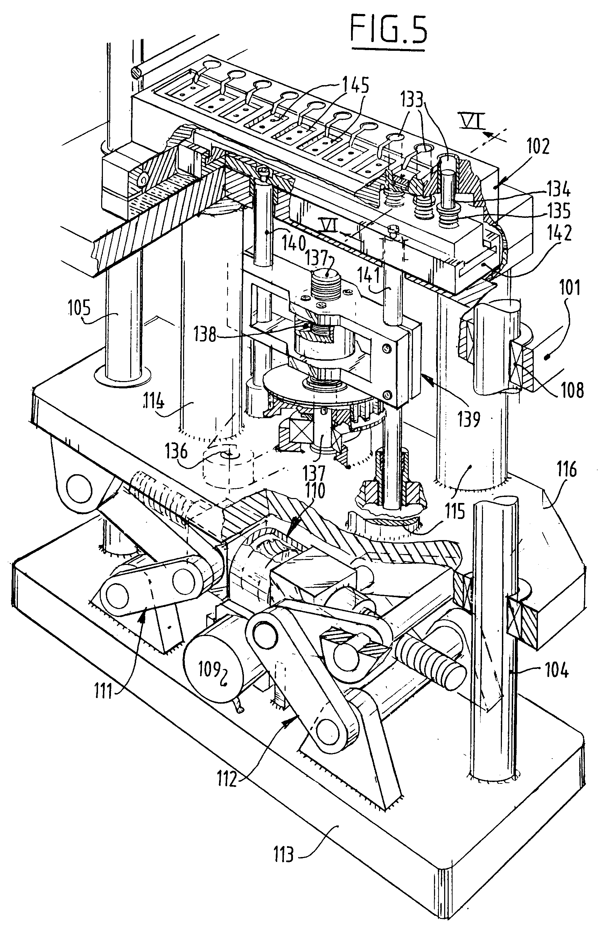

A further more detailed description will now be given with reference to figures 4 and 5.

Mounted on the frame 100 of the machine is a fixedly positioned table 101. The table 101 bears a fixed lower mould half 102. The upper mould half 103 is movable relative to the lower half 102 using pull rods 104, 105 which are connected to the upper half 103 by the respective nut connections, 106, 107. The pull rods 104, 105 are movable relative to the fixed table 101 via bearings, for example 108.

The driving of the upper half of the mould 103 takes place from an electromotor 109. Driven by means of the worm box 110 are the angle lever systems 111, 112. The angle lever systems are coupled on the one side to a movable underplate 113 and on the other side to a plate 116 fixedly connected to the table 101 by means of columns 114, 115. When the electromotor rotates the underplate 113 is moved vertically, for example in the direction of the arrow P1, which movement is transmitted via the pull rods 104, 105 onto the upper mould half 103. At the end of the stroke the arms of the angle lever system 111, 112 lie practically in one line so that a very great closing force is achieved.

The input carriage 117 is movable over the guide rails 118, 119. The driving of the input carriage 117 takes place from the electromotor 120.

Leadframes are supplied from a supply cassette and are carried up over the belts 122, 123 as far as a stop 124. During the position of the input carriage 117 outside the mould the input carriage 117 is filled from a so-called pellet-filling carriage 125 with pellet-shaped moulding material which is taken from a supply reservoir 126. For a reliable take-over of pellet-shaped moulding material by the input carriage 117 from the pellet transporting carriage 125 use is made in both carriages of pin-shaped guiding means 127. The mutual movements are controlled using a sensor 128.

The cleaning-discharge unit 129 is likewise movable over the rails 118, 119 between the position outside the mould die and the position inside the mould die. The unit 129 consists of a cleaning-brushing device 130 and a discharge member 131. The cleaning device 130 brushes both mould halves after use and simultaneously sucks up brushed-off remnants. Co-acting with the unit is a break-off plate 132 which subjects the finished product to an after-processing.

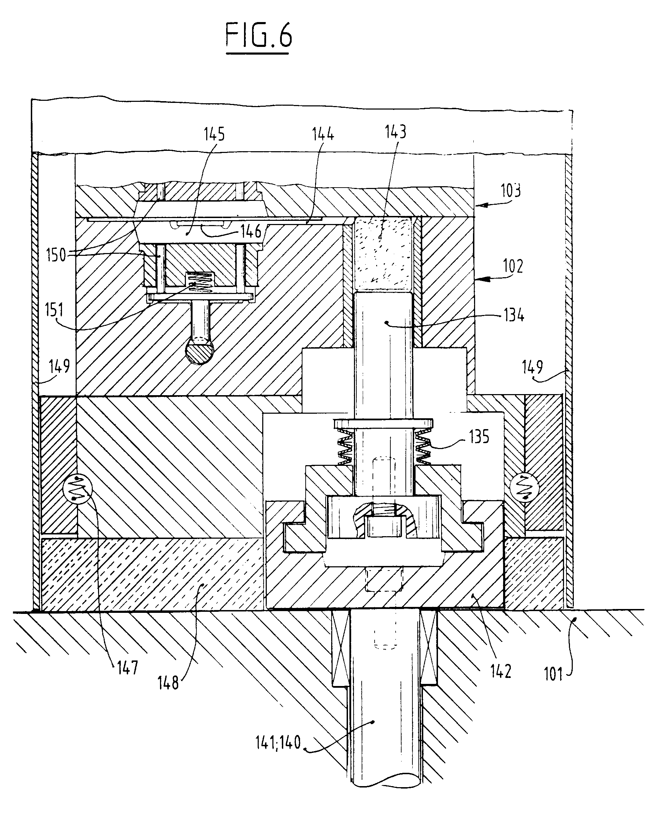

As can be seen in figure 5, the cavities 133 in the lower half 102 of the mould are each provided with a plunger 134 which (see also figure 6) is biased by a spring washer 135 such that the position of the plunger is adapted to the quantity of moulding material in the relevant cavities 133. The plungers are driven from an electromotor which drives a screwed rod 137 via the speed control 136. A nut 138 is placed on the screwed rod so that the rotating movement is converted into a vertically directed movement of the frame 139. Fixedly coupled to the frame are the drive rods 140, 141 for the plunger bracket 142 which in turn drives the plungers. As can be seen from the section VI-VI in figure 5 shown on a larger scale in figure 6, the pellet-shaped moulding material 143 is compressed during the ascending movement and transported via the channel 144 to the cavity 145 in the lower half of the mould where the chip 146 is arranged. As can be further seen in figure 6 a heating coil 147 is arranged for heating the lower half of the mould. The lower half of the mould is insulated by means of insulating material 148. Also visible in figure 6 is the protective cover 149.

In order to improve removal of the finished product a push-out pin 150 under bias of a spring 151 is arranged near the cavity 145.

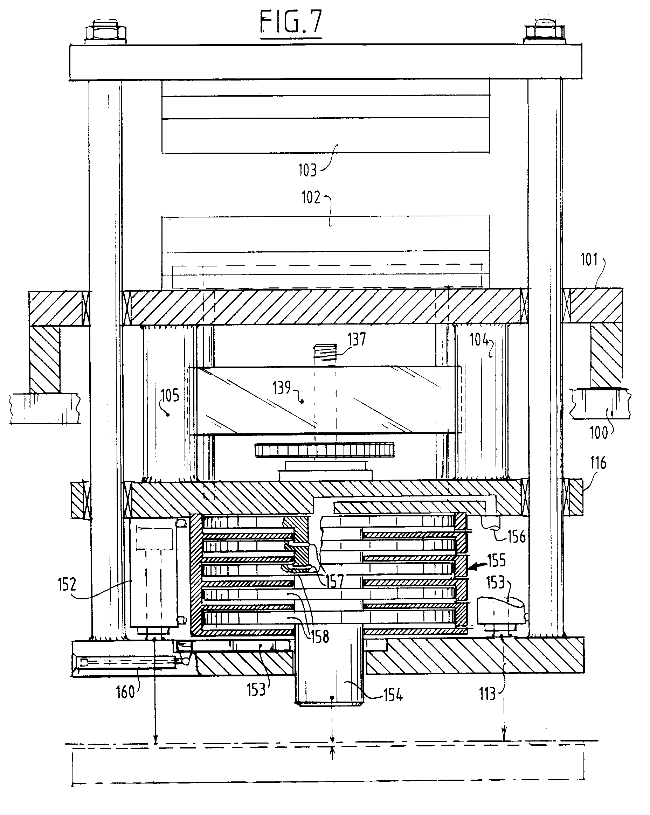

The embodiment according to figure 7 shows another embodiment for displacement of the upper half of the mould and the generating of the required great closing force.

Pneumatic cylinders 152 and 153 displace the upper half of the mould via the movable underplate 113, as in the case of the first discussed embodiment. At the end of the stroke the slide 153 is pushed under the piston rod 154 so that a closed piston-plunger 155 is created. Via the channel compressed air is subsequently admitted from a source 156 (not drawn) which is distributed via the sub-channels, for example 157, over pistons, for example 158, arranged on the piston rod 154. As a result of the large suction surface obtained by the combination of the pistons 158 arranged parallel on the rod 154 a very great closing force is achieved with a small stroke. This is transmitted to the plate 113 and therefore to the upper half of the mould 103. It is further noted that the closing of the slide takes place by means of the plunger 160.

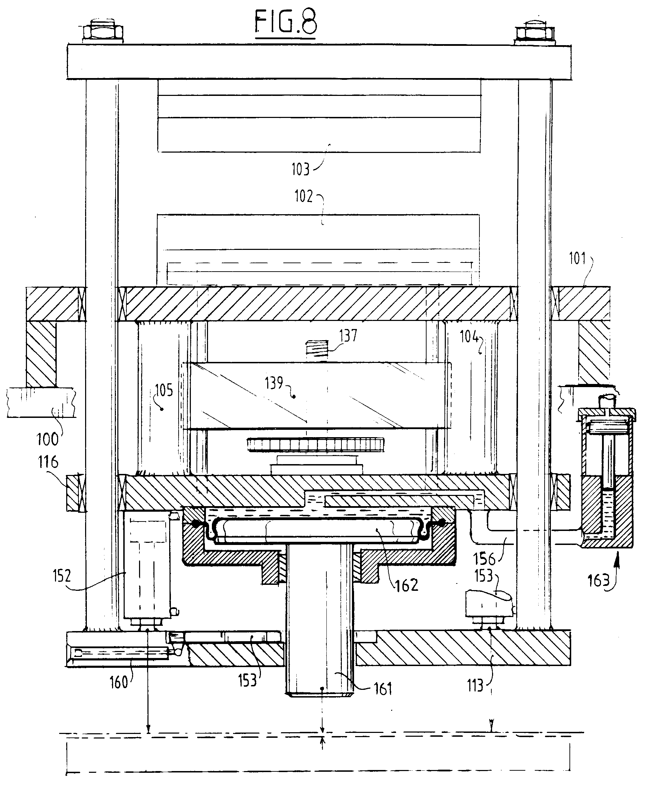

Figure 8 shows an alternative embodiment of the closing mechanism of the mould of the moulding apparatus according to the invention.

A discussion of those parts which correspond with the embodiment according to figure 7 is omitted.

The closing force of the mould halves is provided in this case by a piston-diaphragm cylinder unit filled with liquid. The plunger 161 is moved by the pressure of the liquid exerted on the piston 162, which is derived from the control cylinder 163. This is in contact with the cylinder space of the plunger 161 via the line 156.

Preferably a device 200 for measuring the closing force of one of the halves of the moulds is with respect to the other mould half is provided in the linkage for transferring the force from the electromotor to the movable mould half. Upon receiving a predetermined value of the closing force, a control signal is generated that is applied to stop the driving electromotor.

## Claims

1. Single-strip moulding apparatus comprising a mould formed by two mould halves (1, 2; 102, 103) vertically movable relative to one another and closable onto one another, means (13; 125) for carrying moulding material into cavities (133) of the mould, means (134) for exerting pressure and supplying heat to said cavities (133) to liquify the moulding material and channels (144) for supplying said moulding material to recesses (145), means for heating the mould halves (1, 2; 102, 103), means (6) for cleaning the mould halves (1, 2; 102, 103) and means (5) for removing a moulded product (3) from the mould, **characterized in that**, the moulding apparatus comprises an input carriage (9; 117) for placing a leadframe (10) supporting at least one electronic component into one of the mould halves (1, 2; 102, 103), and in that the means (5, 6) for cleaning and for removing the formed product are unified into a cleaning-discharge unit (4; 129), said cleaning-discharge unit (4; 129) removing the product (3) from the one side, said input carriage (9; 117) for placing the leadframe (10) supplying said leadframe (10) from the other side of the mould and said cleaning-discharge unit (4; 129) and said input carriage (9; 117) performing a reciprocating movement into the mould.

2. Apparatus as claimed in claim 1, **characterized in that** said cleaning-discharge unit (4; 129) to perform a reciprocating movement, cleans during the backward movement the one mould half (2; 103; 1; 102) removes in the forward movement said moulded product (3) and cleans the other mould half (1; 102; 2; 103) one operating stroke.

3. Apparatus as claimed in claims 1-2, **characterized in that** said apparatus comprises a motor (120) that immediately following the return movement of said unit (4; 129) activates said input carriage (9; 117) for placing the leadframe (10) into the mould.

4. Apparatus as claimed in claims 1-3, **characterized in that** said input carriage (9; 117) for placing the leadframe (10) is formed by a first carriage movable over guiderails (118, 119) and that said cleaning-discharge unit (4; 129) is placed on a second carriage movable over these guide rails (118, 119).

## Patentansprüche

1. Einzelband-Formvorrichtung mit einer Form, welche aus zwei Formhälften (1,2; 102,103) gebildet wird, die relativ zueinander vertikal bewegbar und aufeinander verschließbar sind, mit Mitteln (13, 125) zum Fördern von Formmasse in Hohlräume (133) der Form, mit Mitteln (134) zum Aufbringen von Druck auf und zum Zuführen von Wärme zu den Hohlräumen (133), um die Formmasse zu verflüssigen, und mit Kanälen (144) zum Zuführen der Formmasse zu Vertiefungen (145), sowie mit Mitteln zum Erwärmen der Formhälften (1,2; 102,103), mit Mitteln (6) zum Reinigen der Formhälften (1,2; 102,103) und mit Mitteln (5) zum Entfernen eines geformten Produktes (3) aus der Form, dadurch gekennzeichnet, daß die Formvorrichtung umfaßt: einen Zuführschlitten (9;117) für das Positionieren eines Führungsrahmens (10), welcher mindestens ein elektronisches Bauteil trägt, in einer Formhälfte (1,2; 102, 103), und daß die Mittel (5,6) zum Reinigen und Entfernen des geformten Produktes zu einer Reinigungs-Entladeeinheit (4;129) zusammengefaßt sind, wobei die Reinigungs-Entladeeinheit (4;129) das Produkt (3) von der einen Seite entfernt, der Zuführschlitten (9;117) für das Positionieren des Führungsrahmens (10) den Führungsrahmen (10) von der anderen Seite der Form zuführt und die Reinigungs-Entladeeinheit (4;129) und der Zuführschlitten (9;117) eine Hin- und Herbewegung in die Form ausführen.

2. Vorrichtung nach Anspruch 1, dadurch gekennzeichnet, daß die Reinigungs-Entladeeinheit (4;129) bei einer Hin- und Herbewegung die eine Formhälfte (2;103;1;102) während der Rückwärtsbewegung reinigt, in der Vorwärtsbewegung das geformte Produkt (3) entfernt und die andere Formhälfte (1;102; 2;103) in einem Betriebshub reinigt.

3. Vorrichtung nach den Ansprüchen 1 bis 2, dadurch gekennzeichnet, daß die Vorrichtung einen Motor (120) aufweist, der unmittelbar nach der Rückkehrbewegung der Einheit (4;129) den Zuführschlitten (9;117) zum Positionieren des Führungsrahmens (10) in die Form aktiviert.

4. Vorrichtung nach den Ansprüchen 1-3, dadurch gekennzeichnet, daß der Zuführschlitten (9;117) zum Positionieren des Führungsrahmens (10) durch einen über Führungsschienen (118,119) bewegbaren ersten Schlitten gebildet wird, und daß die Reinigungs-Entladeeinheit (4; 129) auf einem zweiten über diese Führungsschienen (118,119) bewegbaren Schlitten plaziert ist.

## Revendications

1. Dispositif de moulage mono-bande, comprenant un moule formé de deux moitiés de moule (1, 2; 102, 103) mobiles verticalement l'une par rapport à l'autre et se fermant l'une sur l'autre, des moyens (13; 125) pour apporter une matière de moulage dans des cavités (133) du moule, des moyens (134) pour exercer une pression et délivrer de la chaleur auxdites cavités (133) pour liquéfier la matière de moulage et des canaux (144) pour délivrer ladite matière de moulage à des renfoncements (145), des moyens pour chauffer les moitiés de moule (1, 2; 102, 103), des moyens (6) pour nettoyer les moitiés de moule (1, 2; 102, 103) et des moyens (5) pour retirer du moule un produit moulé (3), caractérisé en ce que le dispositif de moulage comprend un chariot d'entrée (9; 117) pour placer un châssis directeur (10) portant au moins un composant électronique dans l'une des moitiés de moule (1, 2; 102, 103), et en ce que les moyens (5, 6) pour nettoyer et retirer le produit formé sont unifiés en une unité de nettoyage-évacuation (4; 129), ladite unité de nettoyage-évacuation (4; 129) retirant le produit (3) depuis un côté, ledit chariot d'entrée (9; 117), qui est destiné à placer le châssis directeur, (10) amenant le châssis directeur (10) depuis l'autre côté du moule et ladite unité de nettoyage-évacuation (4; 129) et ledit chariot d'entrée (9; 117) effectuant un mouvement de va-et-vient dans le moule.

2. Dispositif selon la revendication 1, caractérisé en ce que ladite unité de nettoyage-évacuation (4; 129), afin d'effectuer un mouvement de va-et-vient, nettoie pendant le mouvement vers l'arrière la première moitié du moule (2; 103; 1; 102), retire lors du mouvement vers l'avant ledit produit moulé (3) et nettoie l'autre moitié de moule (1; 102; 2; 103) en une course de fonctionnement.

3. Dispositif selon les revendications 1-2, caractérisé en ce que ledit dispositif comprend un moteur (120) qui, immédiatement après le mouvement de retour de ladite unité (4; 129), active ledit chariot d'entrée (9; 117) pour placer le châssis directeur (10) dans le moule.

4. Dispositif selon les revendications 1-3, caractérisé en ce que ledit chariot d'entrée (9; 117), destiné à placer le châssis directeur (10), est formé d'un premier chariot mobile sur des rails de guidage (118, 119) et en ce que ladite unité de nettoyage-évacuation (4; 129) est placée sur un deuxième chariot mobile sur ces rails de guidage (118, 119).
